# FASCICULE DE BREVET EUROPEEN

(11) **EP 3 537 489 B1**
(45) Date de publication et mention de la délivrance du brevet: **01.06.2022**
(21) Numéro de dépôt: 18213769.5
(22) Date de dépôt: 18.12.2018
(51) Int. Cl.: H01L 45/00

(54) **PROCÉDÉ DE FABRICATION D'UN DISPOSITIF TRAVERSANT**
HERSTELLUNGSVERFAHREN EINER DURCHLAUFENDEN VORRICHTUNG
METHOD FOR MANUFACTURING A PENETRATING DEVICE

(30) Priorité: 21.12.2017 FR 1762757
(43) Date de publication de la demande: 11.09.2019
(73) Titulaire: Commissariat à l'Energie Atomique et aux Energies Alternatives, 75015 Paris (FR)
(72) Inventeur: CHARPIN-NICOLLE, Christelle, 38120 Fontanil-Cornillon (FR); GASSILLOUD, Rémy, 38380 Saint-Laurent-du-Pont (FR); PERSICO, Alain, 38400 Saint-Martin-d'Hères (FR)
(74) Mandataire: Hautier IP

(56) Documents cités:
- US-A- 6 117 720
- US-A1- 2007 037 316
- US-A1- 2008 128 853
- US-A1- 2009 035 514
- US-A1- 2012 280 199
- US-A1- 2013 075 682

## Description

### DOMAINE DE L'INVENTION

La présente invention concerne les dispositifs électroniques dotés de vias.

Par dispositif microélectronique, on entend tout type de dispositif réalisé avec les moyens de la microélectronique.

Ces dispositifs englobent notamment, en plus des dispositifs à finalité purement électronique, des dispositifs micromécaniques ou électromécaniques (MEMS, NEMS...) ainsi que des dispositifs optiques ou optoélectroniques (MOEMS...).

Une application non limitative de l'invention est la technologie des dispositifs à mémoire et plus particulièrement à mémoire résistive non volatile. En particulier, les mémoires OXRAM sont visées. Les mémoires résistives de type OxRRAM (acronyme en anglais pour « Oxide-Based Resistive Random Access Memories ») comprenant typiquement une couche d'oxyde métallique, sont étudiées pour des applications non-volatiles, dans le but de remplacer les mémoires de type Flash. Elles présentent notamment pour avantage d'être compatibles avec le procédé de fin de ligne (acronyme BEOL en anglais pour « Back-End Of Line ») de la technologie CMOS (acronyme en anglais pour « Complementary Metal-Oxide-Semiconductor »). Les mémoires résistives OxRRAM sont des dispositifs comprenant notamment une couche d'oxyde métallique disposée entre deux électrodes. La résistance électrique de tels dispositifs peut être modifiée par des opérations d'écriture et d'effacement. Ces opérations d'écriture et d'effacement permettent de faire passer le dispositif à mémoire résistive OxRRAM d'un état haute résistance HRS (acronyme en anglais pour « High Resistive State ») à un état basse résistance LRS (acronyme en anglais pour « Low Resistive State ») et inversement.

### ETAT DE LA TECHNIQUE

Les vias, notamment les plugs en tungstène, ont connu un essor important dans le secteur de la microélectronique dans la mesure où ils permettent un raccordement électrique suivant l'épaisseur des empilements de couches des dispositifs, autorisant par exemple en cela des architectures en trois dimensions.

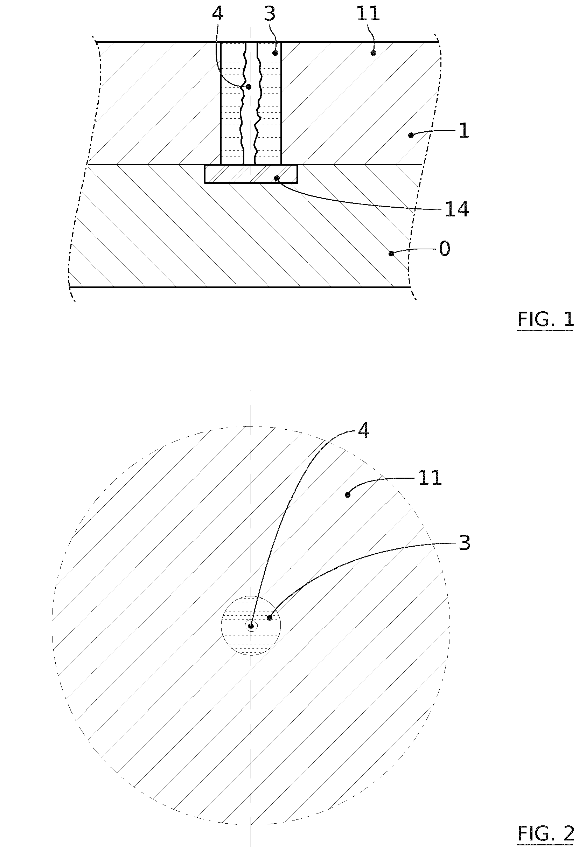

La tendance systémique de la microélectronique à réduire les dimensions des composants rend cependant dorénavant plus difficile la fabrication qualitative des vias. Ainsi, les diamètres des vias sont parfois très petits en comparaison avec leur hauteur, de sorte que les rapports de forme sont devenus élevés ; dans de telles situations, le remplissage des vias devient problématique. La figure 1 illustre en coupe longitudinale un via 3 par exemple en tungstène selon l'état de la technique au travers d'une couche 1 d'un substrat 0. On note des zones non remplies, c'est-à-dire des vides 4, appelées voids, dans la partie centrale du via, zones constitutives de défauts induits (ou inhérent au procédé de dépôt (notamment par dépôt chimique en phase vapeur (CVD)) et pouvant altérer l'efficacité du via, notamment en termes de fiabilité électrique.

La figure 2 montre l'extrémité supérieure d'un via 4 portant un tel défaut de surface, dans un cas non limitatif de section circulaire de via.

Il existe donc un besoin de proposer un dispositif et un procédé pour sa fabrication permettant d'améliorer les techniques connues jusqu'à présent, notamment quant à la présence de défauts, tels des voids, dans les vias. Il existe aussi un besoin d'améliorer la fabrication de dispositifs microélectroniques du type mémoires.

La publication brevet US 2008/128853 A1 présente une utilisation de via traversant pour intégrer des cellules mémoire. La publication brevet US 2007/037316 A1 divulgue la formation d'une électrode inférieure de cellule mémoire dans un via. La publication brevet US 6117720 divulgue un via d'une cellule mémoire.

### RESUME DE L'INVENTION

Suivant un premier aspect, l'invention concerne un procédé de réalisation d'un via au travers d'une couche de base d'un dispositif microélectronique selon la revendication indépendante 1, comprenant une formation d'un trou débouchant sur au moins sur une première face de la couche de base et un remplissage du trou par au moins un premier matériau de remplissage.

Z Ce procédé de réalisation comprend un enlèvement au moins partiel du matériau de remplissage sur une profondeur depuis la première face de la couche de base, la profondeur étant strictement inférieure à une dimension en épaisseur du trou, de sorte à produire une portion en creux, et en ce qu'il comprend un deuxième remplissage, au moins partiel, de la portion en creux par au moins un deuxième matériau de remplissage.

Ainsi, le remplissage de la portion en creux s'opère dans des conditions plus favorables dans la mesure où la profondeur de ce deuxième remplissage est réduite. Cela favorise la qualité de cette portion du via, notamment en termes de nombres de défauts ou de vides (voids en anglais) de cette partie. Eventuellement, le remplissage de la portion en creux est l'opportunité de choisir un deuxième matériau différent du premier matériau.

Le deuxième remplissage comprend la formation d'une couche électriquement conductrice immédiatement au-dessus du premier remplissage, ce dernier étant de préférence configuré pour former un élément électriquement conducteur. Cette disposition permet de disposer d'une couche électriquement conductrice déposée, par le deuxième remplissage, dans de meilleures conditions de sorte à obtenir, in fine, une surface de contact électrique de meilleure qualité. Par exemple, cela peut servir à disposer d'une meilleure interface électrique avec des couches superposées, notamment une couche active. Dans ce contexte, l'enlèvement et le deuxième remplissage servent donc, non exclusivement, à produire un élément conducteur global de meilleure qualité de contact électrique avec un autre composant.

L'enlèvement est configuré pour que la portion en creux ait un rapport de forme inférieur à celui du trou initial. Le rapport de forme (ratio égal à profondeur/largeur de la cavité considérée) est alors moins élevé pour la portion en creux qu'il ne l'était pour le trou lui-même. On pourra éventuellement prendre la largeur de la cavité au niveau de son extrémité débouchante comme base de calcul. La profondeur de l'enlèvement permet de régler ce rapport de forme, notamment selon la cinétique d'une gravure. Plus le rapport de forme est faible, plus on limite les vides possibles dans le remplissage de la portion en creux. Il peut par exemple être inférieur à 2, voire à 1, et potentiellement jusqu'à 0.25. On peut atteindre une situation dans laquelle il n'y a plus de vides lors du remplissage, ce qui est le cas, non limitatif, le plus favorable.

### INTRODUCTION DES DESSINS

D'autres caractéristiques, buts et avantages de la présente invention apparaîtront à la lecture de la description détaillée qui suit, en regard des dessins annexés, donnés à titre d'exemple, non limitatif, et sur lesquels :
- la figure 1 présente une vue en coupe d'un dispositif microélectronique avec des vias pourvus de défauts ;
- la figure 2 en donne une illustration en vue de dessus ;
- les figures 3 à 7 montrent des étapes de fabrication d'un via;
- les figures 8 et 9 donnent une variante de via obtenu ;
- les figures 10 à 16 montrent un autre mode de réalisation du via, avec un dispositif au moins partiellement formé dans son volume intérieur, selon l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques, notamment quant à l'épaisseur des différentes couches illustrées.

### DESCRIPTION DETAILLEE

Avant d'entrer dans le détail de différents modes de réalisation, notamment en référence aux figures par la suite introduites, sont énoncées ci-après différentes caractéristiques purement optionnelles et non limitatives que des modes de réalisation peuvent présenter individuellement ou suivant toutes combinaisons entre elles :
- l'enlèvement est configuré pour que la portion en creux 5 ait un rapport de forme inférieur à celui du trou 2 ;
- l'enlèvement est configuré pour que la portion en creux 5 ait un rapport de forme inférieur ou égal à 2 et de préférence inférieur ou égal à 1 ;
- l'enlèvement comprend une gravure ; celle-ci peut être isotrope notamment si l'on souhaite un profil en calotte de la portion en creux; elle peut aussi être anisotrope, notamment si l'on souhaite enlever le premier matériau complètement sur la profondeur de la portion en creux,
- le au moins un premier matériau de remplissage comprend un matériau différent du au moins un deuxième matériau de remplissage ;
- le au moins un deuxième matériau comprend au moins deux couches successives de matériaux différents l'un de l'autre ;
- éventuellement, l'au moins un deuxième matériau comprend au moins une couche électriquement conductrice ; il peut comprendre une pluralité de couches électriquement conductrices empilées ; la au moins une couche électriquement conductrice est avantageusement disposée immédiatement au-dessus du premier élément ; de préférence, le premier élément forme un ensemble électriquement conducteur (dans ce contexte, le au moins un premier matériau de remplissage est électriquement conducteur) et la au moins une couche électriquement conductrice du deuxième remplissage s'inscrit dans la continuité électrique du premier élément ; dans ce contexte, on peut obtenir un meilleur contact électrique. Notamment, le deuxième remplissage est opéré avec un rapport de forme de portion en creux plus favorable que celui du trou, si bien que la ou les couches électriquement conductrices, entamant ou formant l'intégralité du deuxième remplissage, sont déposées dans de meilleures conditions, favorisant l'absence de vide dans leurs couches. Ainsi, dans ce contexte, le premier remplissage est complété par un deuxième remplissage améliorant la qualité de contact électrique. Éventuellement, le deuxième remplissage peut consister en une ou plusieurs couches électriquement conductrices, sans autre couche (en particulier active ou diélectrique) ; dans ce contexte, le premier remplissage et le deuxième remplissage peuvent servir à former un conducteur électrique global exposé au niveau de la première face, et de préférence affleurant au niveau de celle-ci. En particulier, en réalisant un deuxième remplissage ne produisant pas de vide dans les couches, puis en réalisant un enlèvement en surfaces, par exemple par polissage, on obtient une surface de contact électrique de grande qualité. On peut aussi exploiter la pluralité de dépôts de couches, avec au moins deux couches issues respectivement du premier remplissage du deuxième remplissage, pour sélectionner les matériaux les plus appropriés à ces deux phases ;
- le deuxième remplissage comprend un dépôt pleine plaque du au moins un deuxième matériau depuis la première face 11 de la couche de base 1 puis un polissage configuré pour exposer la première face 11 ;
- le deuxième remplissage est configuré pour remplir totalement la portion en creux 5 ;
- le deuxième remplissage comprend une formation d'au moins une couche du au moins un deuxième matériau dans la portion en creux, puis une formation d'un dégagement 17 dans ladite au moins une couche en formant un contour fermé configuré pour définir un empilement 16 d'une portion résiduelle de la au moins une couche circonscrit par le dégagement 17 ;
- la formation d'un dégagement 17 comprend la définition d'un masque 15 au-dessus d'une zone couverte de l'empilement 16 et une gravure configurée pour enlever la au moins une couche en dehors de la zone couverte ;
- le procédé comprend un remplissage au moins partiel de le dégagement 17 par au moins un matériau diélectrique ;
- le remplissage au moins partiel du dégagement 17 comprend au moins un dépôt pleine plaque d'un premier matériau diélectrique 18 puis d'un deuxième matériau diélectrique 19, puis un polissage du deuxième matériau diélectrique 19 employant le premier matériau diélectrique 18 comme couche d'arrêt et configuré pour exposer le premier matériau diélectrique 18 au-dessus de la première face 11, puis un enlèvement d'au moins une partie du premier matériau diélectrique 18 située au-dessus de l'empilement 16, de sorte à exposer ledit empilement 16 ;
- le remplissage est configuré pour remplir totalement le trou 2 ;
- le au moins un deuxième matériau de remplissage comprend, au-dessus de la couche de matériau à changement d'état conducteur, au moins une couche de matériau utilisée pour former au moins une partie d'une deuxième électrode, et dans lequel la première électrode, le matériau à changement d'état conducteur et la deuxième électrode forment une mémoire, de préférence une mémoire résistive non volatile ;
- On forme un élément de reprise de contact 20 en contact avec une surface, exposée sur la première face 11, du au moins un deuxième matériau de remplissage.
- le deuxième élément affleure sur la première face 11 ;
- le au moins un deuxième matériau de remplissage comprend, au-dessus de la couche de matériau à changement d'état conducteur, au moins une couche de matériau d'électrode formant au moins une partie d'une deuxième électrode, et dans lequel la première électrode, le matériau à changement d'état conducteur et la deuxième électrode forment une mémoire, de préférence une mémoire résistive non volatile.
- la couche de matériau d'électrode affleure sur la première face ;
- le deuxième élément est un empilement en saillie au-dessus du premier élément et circonscrit par un dégagement formant un contour fermé autour de l'empilement ;
- le dégagement est rempli d'au moins un matériau diélectrique.

Il est précisé que le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément. Une couche peut par ailleurs être composée de plusieurs sous-couches d'un même matériau ou de matériaux différents.

Il est précisé que l'épaisseur d'une couche se mesure selon une direction perpendiculaire à la surface selon laquelle cette couche présente son extension maximale. Sa largeur s'étend transversalement à cette épaisseur.

Certaines parties du dispositif peuvent avoir une fonction électrique. Certaines sont employées pour des propriétés de conduction électrique et on entend par électrode ou équivalent, des éléments formés d'au moins un matériau ayant une conductivité suffisante, dans l'application, pour réaliser la fonction souhaitée. D'autres parties, au contraire, sont employées pour des propriétés d'isolation électrique et tout matériau ayant une résistivité suffisante pour réaliser cette isolation est concerné et notamment appelé diélectrique.

La figure 1 illustre un dispositif construit sur la base d'un substrat 0, par exemple en silicium, surmonté d'une couche 1 que traverse un ou plusieurs vias 3. Dans cet exemple schématique, le via 3 sert à relier électriquement une plage de connexion 14 du substrat 0 à une face supérieure 11 de la couche 1, par exemple pour raccorder un composant à cet endroit. En figure 2, on observe que la surface supérieure du via 3 est exposée et qu'elle peut assurer une reprise de contact à ce niveau. On a indiqué précédemment les inconvénients que peuvent poser les défauts de remplissage des vias 3 représentés aux figures 1 et 2.

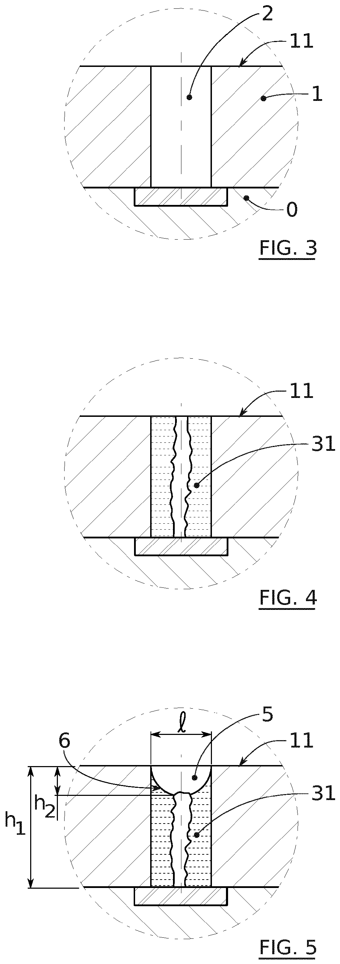

On présente ci-après, en référence aux figures 3 à 7, un procédé permettant de réduire ou de faire disparaitre de tels défauts, au moins sur une partie de la hauteur (qui s'entend de la dimension selon l'épaisseur de la couche traversée par le via ou profondeur) du via 3.

La figure 3 montre un trou 2 dans une couche de base 1. Ce trou 2 est débouchant sur la face 11 de la couche de base 1 par laquelle on souhaite que le via 3 soit accessible pour une utilisation ultérieure. Il n'est pas absolument nécessaire que le trou 2 soit débouchant sur l'autre face de la couche de base 1. Le trou 2 peut être ouvert ultérieurement ou rester fermé et non raccordé électriquement par le bas, ou encore être déjà partiellement rempli à sa base par un matériau conducteur d'électricité. Le trou 2 est par exemple de section transversale circulaire mais cela n'est pas limitatif. Il peut notamment aussi être de section carrée ou rectangulaire. On appelle ici largeur ou diamètre, la plus grande dimension du trou 2 ou du via 3 dans un plan perpendiculaire à l'épaisseur de la couche 1. C'est typiquement le diamètre pour le cas d'une section circulaire ou le plus grand côté pour un cas rectangulaire ou la dimension de tout côté dans le cas d'une section carrée.

L'invention ne fait pas d'hypothèse quant au matériau de la couche 1 ; il peut notamment s'agir de dioxyde de silicium ou de nitrure de silicium. Le trou 2 peut être obtenu par une gravure de nature courante.

En figure 4, on a réalisé un premier remplissage 31 du trou 2. Ce remplissage 31 peut être produit en une ou plusieurs étapes et peut impliquer un ou plusieurs premiers matériaux de remplissage. Par exemple, on peut déposer une couche de nitrure de titane (ou deux couches respectivement de titane et de nitrure de titane), puis finaliser le premier remplissage majoritairement par du tungstène de sorte à remplir autant qu'il est possible le volume intérieur du trou 2. De préférence, le remplissage s'opère par déposition chimique en phase vapeur (dont l'acronyme est CVD). Mais on peut aussi avoir recours à d'autres modes de remplissage en complément ou en alternative au CVD, en particulier le dépôt physique en phase vapeur (PVD), par exemple pour une couche de TiN. Il peut être suivi d'un polissage de sorte à éliminer les dépôts ayant recouvert la face 11 de la couche 1.

La hauteur du trou, h1, est dans l'exemple assez grande relativement à sa largeur, I, si bien que le rapport de forme h1/I est élevé (typiquement supérieur à 2, et possiblement supérieur voire très supérieur à 10), ce qui rend difficile un remplissage complet du via 3 et, en l'occurrence, un vide 4 subsiste dans la matière du premier remplissage, ce vide débouchant parfois sur la face 11.

A ce stade, on réalise un enlèvement de la matière du premier remplissage 31. Cet enlèvement n'est pas intégral, mais au contraire n'a lieu que sur une partie de la profondeur du trou depuis la face 11 de la couche de base 1. Avantageusement, la profondeur d'enlèvement est inférieure à la moitié, voire au tiers, de la hauteur h1. Avantageusement on choisit la profondeur h2 d'enlèvement, visible en figure 5, telle que le rapport h2/I soit inférieur ou égal à 2, voire inférieur à 1 ; il peut être supérieur ou égal à 0.25.

Suivant une option de l'invention, l'enlèvement est une gravure, Si le premier remplissage était multicouche, il n'est pas obligatoire de procéder à un enlèvement d'une portion de chacune de ces couches ; on peut notamment ne graver que la partie la plus centrale du via, celle au niveau ou à proximité de son axe longitudinal. Une gravure sèche ou humide peut convenir, notamment à base de SF6 pour attaquer du tungstène. On peut former un bord de gravure, au niveau de la surface 6 exposée de la matière du premier remplissage 31. De cette manière, on favorise une portion en creux 5 en forme de cuvette, l'épaisseur résultant du premier remplissage étant décroissante en direction de la face 11.

La portion en creux s'entend d'une partie en forme de cavité dans le trou, mais sur une hauteur moindre que celle de trou. Dans le cas de la figure 5, l'enlèvement est progressif en largeur depuis la surface, et ici en forme de calotte, si bien que le premier matériau de remplissage subsiste sur des bords latéraux de la portion en creux, bords ayant une composante non nulle selon la profondeur du trou. Il est aussi possible de disposer d'une paroi de portion en creux qui est dirigée uniquement selon la hauteur de cette dernière, par exemple en forme de cylindre, de section circulaire ou non , s'inscrivant dans le trou ; le au moins un premier matériau de remplissage entoure alors au moins en partie cette cavité. Une autre possibilité est d'enlever totalement le premier matériau de remplissage sur une profondeur donnée si bien que la portion en creux consiste en un étage complet du trou originel. En particulier, le fond de la portion en creux est possiblement une face supérieure, avantageusement plane, du premier matériau de remplissage préservé plus dans le fond du trou.

Cette démarche d'enlèvement, quelle qu'en soit la variante, est en contradiction avec un procédé classique de fabrication de via puisqu'elle pourrait apparaitre comme contre-productive ; cependant on verra que cette phase est avantageuse.

En effet, l'enlèvement produit une portion en creux 5 dont la hauteur est plus faible que la hauteur de remplissage initiale ; et le rapport de forme est aussi de préférence réduit. On peut dès lors exécuter une deuxième phase de remplissage, de la portion en creux 5. Comme dans le cas du premier remplissage, il peut s'agir d'un dépôt multicouche. Une première couche 7 peut être une couche d'accroché favorisant une bonne interface entre la matière exposée du premier remplissage 31 et des couches ultérieures du deuxième remplissage. Si le matériau sous-jacent était du tungstène, on peut par exemple entamer le deuxième remplissage par une couche 7 d'accroché en nitrure de titane ou en titane. Puis le deuxième remplissage peut se poursuivre par un deuxième dépôt, par exemple de tungstène. Le deuxième remplissage peut comprendre, ou consister, en une ou plusieurs couches électriquement conductrices d'un même matériau ou de matériaux différents.

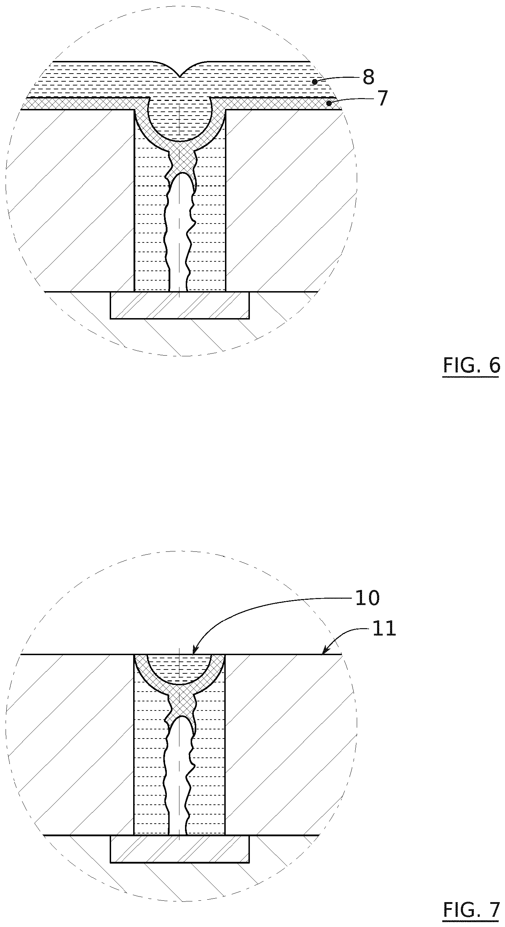

Dans le cas de la figure 6, on s'arrange pour que le deuxième remplissage occupe la totalité du volume de la portion en creux 5 du trou 2. Compte-tenu des dimensions mises en jeu dans cette deuxième phase de remplissage, les vides sont limités voire supprimés dans la zone en question. De plus l'éventail de techniques de dépôt est élargi par le fait que les épaisseurs des couches à former sont plus faibles. On peut notamment plus facilement recourir à des dépôts de couches atomiques (dont l'acronyme est ALD), et du fait que le rapport d'aspect est moins élevé, on peut notamment recourir à des dépôts physiques en phase vapeur (dont l'acronyme est PVD).

La figure 7 présente un exemple de résultat final après polissage de sorte à éliminer les parties des dépôts qui ont pu couvrir la face 11 de la couche 1. On comprend que la face supérieure 10 du via 3 ainsi finalisée est de meilleur état de surface que selon les techniques traditionnelles. Avantageusement, elle est sans vide.

On notera que le remplissage peut être rendu homogène entre la première phase et la deuxième phase de remplissage, en employant au moins un matériau identique durant ces deux phases, et notamment un matériau occupant une majorité du volume de remplissage de ces deux phases. Ce peut être le cas du tungstène. On peut aussi employer au moins un matériau pour la deuxième phase différant du ou des matériaux employés dans la première phase. Le via 3 s'en trouve composite. Un matériau majoritaire en volume lors du premier remplissage peut être différent d'un matériau majoritaire lors du deuxième remplissage. Comme exemples de matériaux utilisables pour le deuxième remplissage, on peut aussi citer les matériaux suivants TaN, Ta, Co, Ru, Ni, Cu, HfN, AI, WxTiy, TixAly, TixAlyN, TaxAly, TaxAlyN, matériaux que l'on ne retrouvent avantageusement pas lors du premier remplissage.

On a ainsi obtenu un via dont la face 10 assure un meilleur contact avec un composant à raccorder. En ce sens, le via peut notamment servir de raccordement dans une approche de construction de « back end of line », ou encore d'électrode, ou de partie d'électrode, pour un composant rapporté par le dessus de la face 11 de la couche 1, par exemple un actionneur, un capteur, une batterie ou une mémoire.

Dans ce dernier contexte, on peut employer l'invention pour former au moins une partie d'un dispositif mémoire. D'une manière générale, un dispositif mémoire peut être porté par un support, par exemple à base d'un substrat, notamment semi-conducteur. Une pluralité de dispositifs sera généralement réalisée sur ce support.

Dans l'état initial, le matériau actif est isolant (dans un état dit PRS, « Pristine Résistance State »). On entend par matériau actif celui au sein duquel une phase de forming puis des états conducteurs ou non vont se produire comme expliqué ci-après. Un premier stress électrique est appliqué sur la mémoire résistive vierge afin de générer pour la première fois un état conducteur faiblement résistif LRS (de l'anglais « Low Résistance State »). Le processus associé est appelé forming. La mémoire résistive peut ensuite basculer de l'état conducteur faiblement résistif LRS à un état hautement résistif HRS (de l'anglais « High Résistance State ») par l'application d'une première tension VRESET entre les première et seconde électrodes, et rebasculer de l'état conducteur hautement résistif HRS à l'état conducteur faiblement résistif LRS par l'application d'une deuxième tension VSET entre les première et deuxième électrodes. Elle peut donc être utilisée pour stocker une information binaire. L'état conducteur faiblement résistif LRS est également appelé état « ON ». L'état conducteur hautement résistif HRS est également appelé état « OFF ».

Le phénomène de changement de résistance est observé dans différents types de matériaux, ce qui suggère des mécanismes de fonctionnement différents. On peut ainsi distinguer plusieurs types de mémoires résistives. Le domaine concerné est plus particulièrement celui de deux catégories de mémoires résistives :
- les mémoires comportant une zone active basée sur un matériau actif à base d'oxyde (mémoire OxRRAM ou « Oxyde RRAM ») tel qu'un oxyde binaire d'un métal de transition ;
- les mémoires comportant une zone active basée sur un matériau à conduction ionique (mémoires CBRAM ou « Conductive Bridging RAM ») formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode.

Le changement d'état résistif dans une mémoire résistive de type OxRRAM est généralement expliqué par la formation d'un filament de lacunes d'oxygène au sein de la zone active. Le changement d'état résistif dans une mémoire résistive de type CBRAM est généralement expliqué par la formation d'un filament conducteur au sein de la zone active.

Avec le via 3 de la figure 7, dans le cas où il forme un élément conducteur assimilable à une partie d'électrode inférieure, la surface exposée de la face 10 du via 3 est nettement améliorée relativement aux techniques antérieures si bien que l'on peut y empiler une couche de matériau à changement d'état résistif en limitant la dispersion quant aux valeurs de tension de forming.

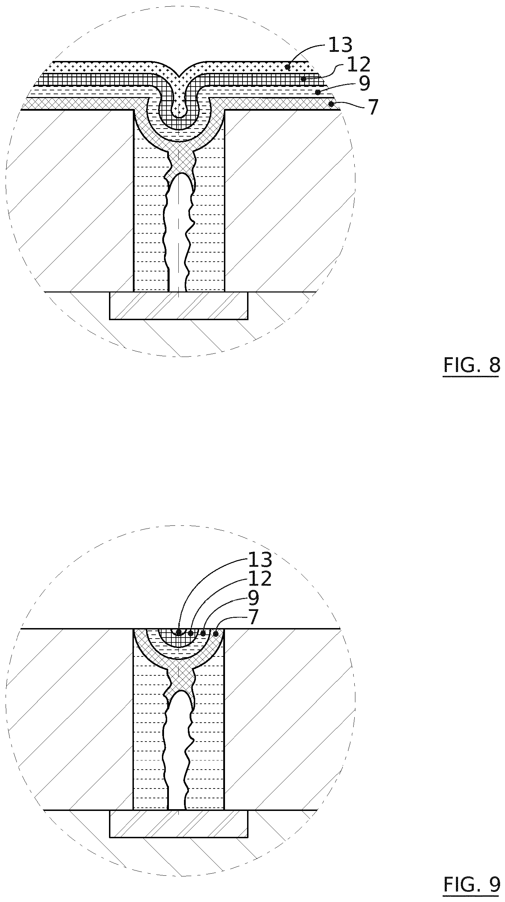

Les figures 8 et 9 illustrent une variante qui ne fait pas parti de l'invention dans une telle application.

En figure 8, sur la base du résultat intermédiaire illustré à la figure 5, on procède à un deuxième remplissage comprenant une succession de couches participant à une mémoire. Par exemple, une couche 7 en nitrure de titane peut revêtir la portion résiduelle du premier remplissage, par exemple en tungstène. On obtient ainsi une première électrode de dispositif mémoire. Ensuite, une couche 9 peut être en un matériau actif, à savoir à changement d'état résistif, comme du HfO₂. On peut poursuivre le remplissage avec au moins une couche 12 et une couche 13 formant ou participant à une deuxième électrode. Cela peut comprendre au moins l'une parmi une couche de titane, une couche de nitrure de titane.

La figure 9 montre un polissage assurant l'enlèvement des dépôts en surface de la couche de base 1.

Bien entendu, des organes de reprise de contact peuvent ensuite être rapportés au-dessus du via 3.

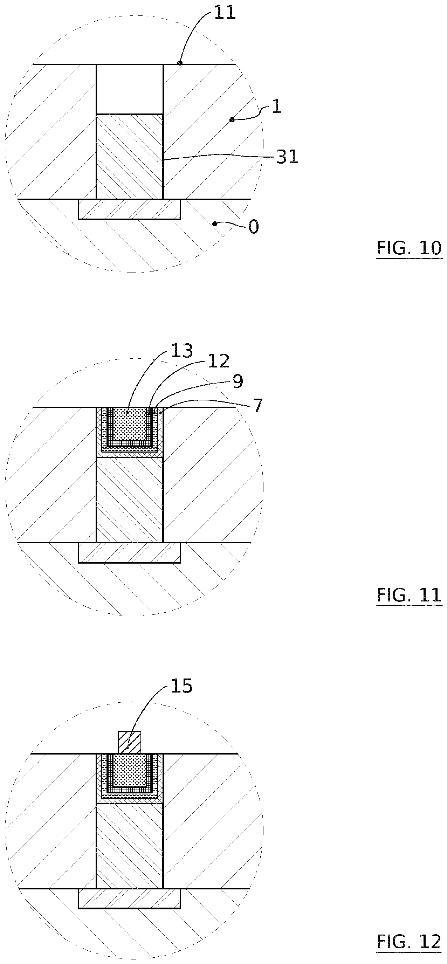

La figure 10 présente une situation alternative au cas de la figure 5 concernant le profil de la portion en creux 5. Le premier remplissage 31 est ici représenté de façon plus schématique en ce sens que les défauts qu'il est susceptible de présenter ne sont pas illustrés. En ce qui concerne la forme de la portion en creux 5, elle correspond à un enlèvement complet de la matière du premier remplissage 31 suivant la profondeur de la portion en creux 5. Les parois latérales du trou sont donc ainsi dégagées. Dans le cas non limitatif d'un trou de section circulaire, la portion en creux correspond à une portion de cylindre. Dans un autre cas non limitatif selon lequel le trou est de section rectangulaire (voire carrée), la portion en creux 5 est parallélépipédique rectangle. On peut obtenir cette configuration de forme par exemple avec une gravure anisotrope creusant progressivement la portion en creux de manière équivalente suivant toute la section de cette dernière.

On notera que ce profil de portion en creux 5 peut être appliqué aux modes de réalisation discutés précédemment. De même, même si ce profil est utilisé dans le cas des figures 11 à 16, il n'est pas limitatif de ce mode de réalisation qui peut recourir à d'autres profils et notamment ceux précédemment discutés.

À la figure 11, on a opéré la fabrication d'une pluralité de couches dans le volume de la portion en creux 5. Il peut s'agir de dépôts pleine plaque successifs d'une pluralité de couches 7, 9, 12 et 13. Toute technique de dépôt, notamment par PVD peut convenir. Avantageusement, mais non limitativement, on réalise ensuite un polissage de sorte à ne préserver le matériau des couches successives que dans la portion en creux et non au niveau de la première face 11, ce qui est révélé en figure 11 car la première face 11 y reste exposée ; cela n'est cependant pas limitatif.

Comme dans le cas précédent, le deuxième remplissage passant par la pluralité de couches 7, 9,12 et 13 peut servir à former un point mémoire ; dans ce contexte, le matériau du premier remplissage 31 peut toujours être un élément conducteur, par exemple du tungstène, et la couche 7 peut être une couche électriquement conductrice rapportée au-dessus du premier remplissage 31, par exemple en TiN. La couche 9 peut comme précédemment être une couche active, par exemple en HfO₂. Ensuite, les couches 12 et 13 peuvent former une partie d'électrode supérieure, en matériau électriquement conducteur tel que, respectivement, du titane et du nitrure de titane. Il est souhaitable que la profondeur et/ou la section de la portion en creux 5 et que les épaisseurs des couches successives du deuxième remplissage soient configurées de sorte à ce que l'intégralité des couches du deuxième remplissage descende vers l'intérieur de la portion en creux de sorte que toutes les couches comportent une portion comprise dans le volume intérieur du trou.

La configuration de la figure 11 est dans ce contexte assez proche de celle présentée en figure 9, hormis le profil de la portion en creux 5. Elle peut servir de point de départ pour une reprise de contact par le dessus, notamment en assurant une continuité électrique entre la couche 13 est un élément de reprise de contact rapporté au niveau de la première face 11.

Cependant, il est avantageux de faciliter la reprise de contact en augmentant l'individualisation de la surface supérieure du deuxième élément constitué par les couches du deuxième remplissage, notamment en évitant que les couches sous-jacentes à la couche supérieure (ici la couche 13) ne soient exposées au niveau de la première face 11. En outre, le point mémoire peut être rendu très petit.

A cet effet, les figures 12 à 16 montrent des étapes successives conduisant à discriminer plus avant la partie conductrice supérieure du deuxième remplissage, comblant au moins en partie la portion en creux 5, relativement aux autres couches de ce deuxième remplissage. Dans l'étape de la figure 12, on a défini un masque 15 au-dessus du deuxième remplissage, de sorte à couvrir une zone, et de préférence pas la totalité, de la surface exposée de la dernière couche du deuxième remplissage, ici la couche 13. Avantageusement, le masque 15 est défini pour ne pas couvrir d'autres couches. Une technique de photolithographie peut convenir dans ce contexte.

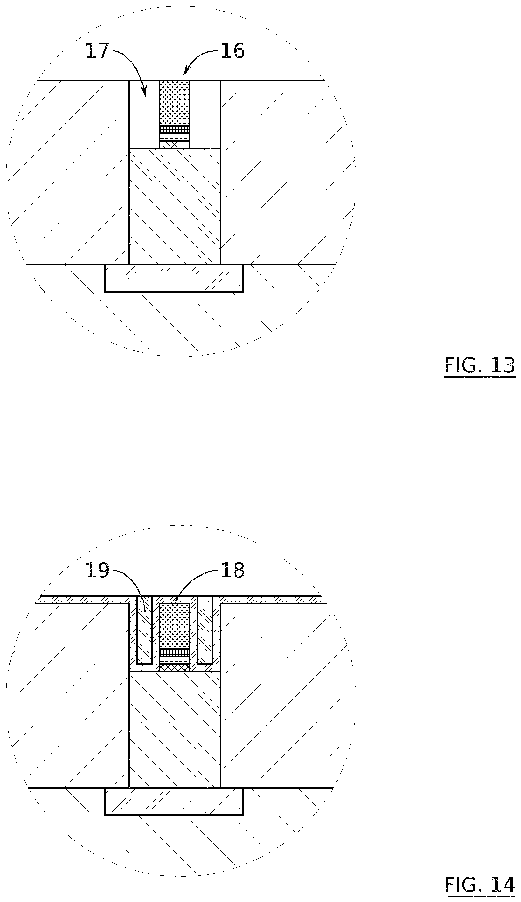

Le masque 15 sert à épargner la zone qu'il recouvre lors d'une étape d'enlèvement du ou des matériaux du deuxième remplissage. Ainsi, la figure 13 montre le résultat d'une gravure opérée dans le deuxième remplissage de sorte à ne conserver les couches de cette dernière qu'en dessous du masque 15 (ce dernier a été enlevé après l'étape de gravure et n'est plus apparent sur la figure 13). Il est souhaitable que la gravure soit fortement anisotrope. On peut notamment utiliser une gravure plasma. De préférence, l'enlèvement produit est poursuivi jusqu'à la face supérieure du premier remplissage 31, en gravant suivant toute la profondeur de la portion en creux 5. En outre, compte tenu que le masque 15 ne protège avantageusement qu'une partie du deuxième remplissage, l'enlèvement conduit à la définition d'un dégagement formant un contour fermé de forme en section équivalente à la forme du masque 15 autour d'une portion résiduelle des couches du deuxième remplissage en dessous du masque 15. Dans le cas de la figure 13, cette portion résiduelle correspond un empilement 16 qui fait saillie depuis la face supérieure du premier remplissage 31 et, dans cet exemple, jusqu'au niveau de la première face 11. On comprend que la forme du dégagement 17 est déterminée par la forme du masque et la forme de l'embouchure du trou initial. On comprend par ailleurs que l'empilement 16 forme un îlot dans la portion en creux 5. Cette individualisation va permettre une reprise de contact améliorée tout en autorisant une petite dimension de la cellule mémoire.

En figure 14, l'empilement 16 se trouve encapsulé par un remplissage solide diélectrique. Ce dernier comprend, dans l'exemple, un premier matériau diélectrique 18, par exemple du SiN, du SiC ou du SiCN, qui tapisse la première surface 11, la paroi latérale de la portion en creux 5, la surface supérieure exposée du premier remplissage 31 et la surface supérieure de l'empilement 16 ainsi que sa paroi latérale. On notera que ce recouvrement permet de préférence de protéger des couches de l'empilement 16 de l'oxydation, notamment en ce qui concerne l'emploi de matériaux assez fortement oxydables tels que le titane. Le remplissage effectué par le premier matériau 18 peut se suffire à lui-même, par exemple en SiO₂. Il n'est d'ailleurs pas absolument nécessaire que le remplissage soit complet dans la dégagement. Cependant, dans le mode de réalisation de la figure 14, on a complété le premier matériau 18 par un deuxième matériau diélectrique 19, par exemple du SiO₂. Dans le cas du SiN notamment, pour le premier matériau 18, on peut produire une couche par PECVD (dépôt chimique en phase vapeur assisté par plasma). Dans le cas du SiO₂ notamment, pour le deuxième matériau 19, on peut produire une couche par PECVD. De préférence, la dégagement 17 se trouve complètement remplie. On peut ensuite opérer un polissage de sorte à enlever le matériau diélectrique 19 en surface. C'est l'état résultant qui est présenté à la figure 14.

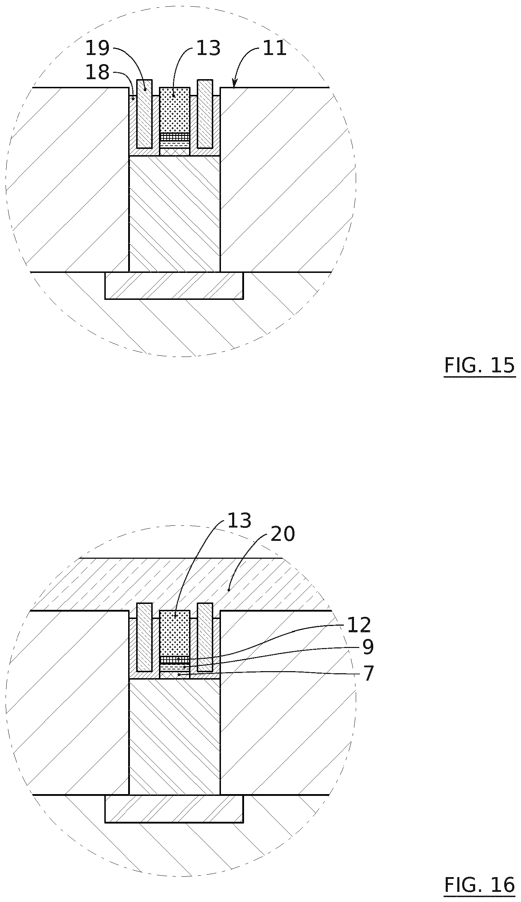

À ce stade, le premier matériau diélectrique 18 recouvre encore l'empilement 16 et la face 11. Une gravure sélective, par exemple gravure sèche (ou éventuellement humide), de ce matériau est alors contrôlée de sorte à supprimer la partie du premier matériau diélectrique 18 au-dessus de l'empilement 16 tout en préservant de préférence le premier matériau diélectrique en-deçà de la surface ainsi exposée de l'empilement 16, comme le montre la figure 15. On comprend de cette figure que la couche supérieure de l'empilement 16 est facilement accessible pour une reprise de contact. Notamment, il peut s'agir d'une couche 13 participant à une deuxième électrode qui peut ainsi être raccordée à un élément de reprise de contact 20 comme le montre la figure 16. Ce dernier peut être un élément métallique ou un autre matériau électriquement conducteur, sous la forme d'un plot ou d'une ligne par exemple, s'étendant sur une portion de la première face 11 potentiellement bien plus grande que l'empilement 16. Il n'y a donc pas de contrainte de taille dans la formation de la reprise de contact 20.

### REFERENCES

- 0.: Substrat
- 1.: Couche de base
- 2.: Trou
- 3.: Via
- 4.: Vide
- 5.: Portion en creux
- 6.: Surface du premier remplissage
- 7.: Première couche
- 8.: Deuxième couche
- 9.: Couche active
- 10.: Surface exposée
- 11.: Face
- 12.: Couche
- 13.: Couche
- 14.: Plage de connexion
- 15.: Masque
- 16.: Empilement
- 17.: Dégagement
- 18.: Premier matériau diélectrique
- 19.: Deuxième matériau diélectrique
- 20.: Elément de reprise de contact

- 31.: Premier remplissage

## Revendications

1. Procédé de réalisation d'un via (3) au travers d'une couche de base (1) d'un dispositif microélectronique, comprenant une formation d'un trou (2) débouchant sur au moins sur une première face (11) de la couche de base (1) et un remplissage du trou (2) par au moins un premier matériau de remplissage formant un élément conducteur d'électricité, le procédé comprenant un enlèvement au moins partiel dudit au moins un premier matériau de remplissage sur une profondeur, dirigée suivant une dimension en épaisseur du trou (2), depuis la première face (11) de la couche de base (1), la profondeur étant strictement inférieure à la dimension en épaisseur du trou (2), de sorte à produire une portion en creux (5), et le procédé comprenant en outre un deuxième remplissage, au moins partiel, de la portion en creux (5) par au moins un deuxième matériau de remplissage, **caractérisé en ce que** le deuxième remplissage comprend une formation d'au moins une couche dudit au moins un deuxième matériau dans la portion en creux, puis une formation d'un dégagement (17) dans ladite au moins une couche en formant un contour fermé configuré pour définir un empilement (16) d'une portion résiduelle de ladite au moins une couche circonscrit par le dégagement (17).

2. Procédé selon la revendication précédente, dans lequel l'enlèvement est configuré pour que la portion en creux (5) ait un rapport de forme, correspondant à un ratio de la profondeur de la portion en creux sur sa largeur, inférieur à celui du trou (2).

3. Procédé selon l'une des revendications précédentes, dans lequel l'enlèvement est configuré pour que la portion en creux (5) ait un rapport de forme inférieur ou égal à 2, et de préférence inférieur ou égal à 1.

4. Procédé selon l'une des revendications précédentes, dans lequel l'enlèvement est configuré pour obtenir une épaisseur de premier matériau de remplissage décroissante en direction de la première face (11) de sorte que la portion en creux (5) soit en forme de cuvette.

5. Procédé selon l'une des revendications 1 à 4, dans lequel le deuxième remplissage comprend la formation d'au moins une couche électriquement conductrice immédiatement au-dessus de l'élément conducteur d'électricité.

6. Procédé selon l'une quelconque des revendications précédentes, dans lequel la formation d'un dégagement (17) comprend la définition d'un masque (15) au-dessus d'une zone couverte de l'empilement (16) et une gravure configurée pour enlever ladite au moins une couche en dehors de la zone couverte.

7. Procédé selon l'une quelconque des revendications précédentes, comprenant un remplissage au moins partiel du dégagement (17) par au moins un matériau diélectrique.

8. Procédé selon la revendication précédente, dans lequel le remplissage au moins partiel du dégagement (17) comprend au moins un dépôt pleine plaque d'un premier matériau diélectrique (18) puis d'un deuxième matériau diélectrique (19), puis un polissage du deuxième matériau diélectrique (19) employant le premier matériau diélectrique (18) comme couche d'arrêt et configuré pour exposer le premier matériau diélectrique (18) au-dessus de la première face (11), puis un enlèvement d'au moins une partie du premier matériau diélectrique (18) située au-dessus de l'empilement (16), de sorte à exposer ledit empilement (16).

9. Procédé selon l'une des revendications précédentes, dans lequel ledit au moins un premier matériau est utilisé pour former au moins une partie d'une première électrode, dans lequel ledit au moins un deuxième matériau comprend une couche d'un matériau à changement d'état conducteur et dans lequel ledit au moins un deuxième matériau de remplissage comprend, au-dessus de la couche de matériau à changement d'état conducteur et à l'opposé de la première électrode, au moins une couche de matériau utilisée pour former au moins une partie d'une deuxième électrode, et dans lequel la première électrode, le matériau à changement d'état conducteur et la deuxième électrode forment une mémoire, de préférence une mémoire résistive non volatile.

## Patentansprüche

1. Verfahren zur Herstellung einer Durchkontaktierung (3) durch eine Basisschicht (1) einer mikroelektronischen Vorrichtung, umfassend ein Bilden eines Lochs (2), das auf mindestens einer ersten Fläche (11) der Basisschicht (1) mündet, und ein Füllen des Lochs (2) durch mindestens ein erstes Füllmaterial, wodurch ein Elektrizität leitendes Element gebildet wird, wobei das Verfahren ein zumindest partielles Entfernen des mindestens einen ersten Füllmaterials über eine Tiefe, gemäß einer Dickendimension des Lochs (2) ausgerichtet, von der ersten Fläche (11) der Basisschicht (1) umfasst, wobei die Tiefe strikt kleiner als die Dickendimension des Lochs (2) ist, so dass ein hohler Teil (5) produziert wird, und das Verfahren weiterhin ein zweites Füllen, zumindest partiell, des hohlen Teils (5) durch mindestens ein zweites Füllmaterial umfasst, **dadurch gekennzeichnet, dass** das zweite Füllen ein Bilden von mindestens einer Schicht des mindestens einen zweiten Materials in dem hohlen Teil, dann ein Bilden eines Freiraums (17) in der mindestens einen Schicht, um eine geschlossene Kontur zu bilden, die dazu konfiguriert ist, einen Stapel (16) eines Restteils der mindestens einen Schicht, die von dem Freiraum (17) abgegrenzt wird, zu definieren, umfasst.

2. Verfahren nach dem vorhergehenden Anspruch, wobei das Entfernen derart konfiguriert ist, dass der hohle Teil (5) ein Formverhältnis aufweist, das einem Verhältnis der Tiefe des hohlen Teils zu seiner Breite entspricht, das kleiner als das des Lochs (2) ist.

3. Verfahren nach einem der vorhergehenden Ansprüche, wobei das Entfernen derart konfiguriert ist, dass der hohle Teil (5) ein Formverhältnis aufweist, das kleiner als oder gleich 2 und vorzugsweise kleiner als oder gleich 1 ist.

4. Verfahren nach einem der vorhergehenden Ansprüche, wobei das Entfernen dazu konfiguriert ist, eine Dicke des ersten Füllmaterials zu erhalten, die in der Richtung der ersten Fläche (11) abnimmt, so dass der hohle Teil (5) schüsselförmig ist.

5. Verfahren nach einem der Ansprüche 1 bis 4, wobei das zweite Füllen die Bildung von mindestens einer elektrisch leitenden Schicht unmittelbar über dem Elektrizität leitenden Element umfasst.

6. Verfahren nach einem der vorhergehenden Ansprüche, wobei das Bilden eines Freiraums (17) die Definition einer Maske (15) über einer bedeckten Zone des Stapels (16) und ein Ätzen, das dazu konfiguriert ist, die mindestens eine Schicht außerhalb der bedeckten Zone zu entfernen, umfasst.

7. Verfahren nach einem der vorhergehenden Ansprüche, umfassend ein zumindest partielles Füllen des Freiraums (17) durch mindestens ein dielektrisches Material.

8. Verfahren nach dem vorhergehenden Anspruch, wobei das zumindest partielle Füllen des Freiraums (17) mindestens eine feste Plattenabscheidung eines ersten dielektrischen Materials (18), dann eines zweiten dielektrischen Materials (19), dann ein Polieren des zweiten dielektrischen Materials (19), wobei das erste dielektrische Material (18) als Stoppschicht eingesetzt wird, und das dazu konfiguriert ist, das erste dielektrische Material (18) über der ersten Fläche (11) freizulegen, dann ein Entfernen von mindestens einem Abschnitt des ersten dielektrischen Materials (18), der sich über dem Stapel (16) befindet, um den Stapel (16) freizulegen, umfasst.

9. Verfahren nach einem der vorhergehenden Ansprüche, wobei das mindestens eine erste Material dazu verwendet wird, mindestens einen Abschnitt einer ersten Elektrode zu bilden, wobei das mindestens eine zweite Material eine Schicht eines Leitungszustandsänderungsmaterials umfasst und wobei das mindestens eine zweite Füllmaterial über der Schicht des Leitungszustandsänderungsmaterials und gegenüberliegend der ersten Elektrode mindestens eine Materialschicht umfasst, die dazu verwendet wird, mindestens einen Abschnitt einer zweiten Elektrode zu bilden, und wobei die erste Elektrode, das Leitungszustandsänderungsmaterial und die zweite Elektrode einen Speicher, vorzugsweise einen nichtflüchtigen resistiven Speicher bilden.

## Claims

1. Method for producing a via (3) through a base layer (1) of a microelectronic device, comprising forming a hole (2) opening out onto at least a first face (11) of the base layer (1) and filling the hole (2) with at least one first filling material forming an electrically conductive element, the method comprising at least partially removing said at least one first filling material to a depth, directed along a thickness dimension of the hole (2), from the first face (11) of the base layer (1), the depth being strictly less than the thickness dimension of the hole (2), so as to produce a recessed portion (5), and the method further comprising a second, at least partial, filling of the recessed portion (5) with at least one second filling material, **characterised in that** the second filling comprises forming at least one layer of said at least one second material in the recessed portion, then forming a clearance (17) in said at least one layer by forming a closed contour configured to define a stack (16) of a residual portion of said at least one layer circumscribed by the clearance (17).

2. Method according to the preceding claim, wherein the removal is configured such that the recessed portion (5) has an aspect ratio, corresponding to a ratio of the depth of the recessed portion to its width, of less than that of the hole (2).

3. Method according to one of the preceding claims, wherein the removal is configured such that the recessed portion (5) has an aspect ratio of less than or equal to 2, and preferably of less than or equal to 1.

4. Method according to one of the preceding claims, wherein the removal is configured to obtain a thickness of first filling material that decreases in the direction of the first face (11) such that the recessed portion (5) is bowl-shaped.

5. Method according to one of claims 1 to 4, wherein the second filling comprises forming at least one electrically conductive layer immediately above the electrically conductive element.

6. Method according to any one of the preceding claims, wherein forming a clearance (17) comprises defining a mask (15) over a covered area of the stack (16) and etching configured to remove said at least one layer outside the covered area.

7. Method according to any one of the preceding claims, comprising at least partially filling the clearance (17) with at least one dielectric material.

8. Method according to the preceding claim, wherein the at least partial filling of the clearance (17) comprises at least one full wafer deposition of a first dielectric material (18), then of a second dielectric material (19), followed by polishing the second dielectric material (19) using the first dielectric material (18) as a stop layer, and configured to expose the first dielectric material (18) above the first face (11), and then removing at least a part of the first dielectric material (18) situated above the stack (16), so as to expose said stack (16).

9. Method according to one of the preceding claims, wherein said at least one first material is used to form at least a part of a first electrode, wherein said at least one second material comprises a layer of a conductance-switching material, and wherein said at least one second filling material comprises, above the layer of conductance-switching material and opposite the first electrode, at least one layer of material used to form at least a part of a second electrode, and wherein the first electrode, the conductance-switching material and the second electrode form a memory, preferably a non-volatile resistive memory.
